# EUROPEAN PATENT APPLICATION

(11) **EP 3 010 045 A1**
(43) Date of publication of application: **20.04.2016**
(21) Application number: 15189734.5
(22) Date of filing: 14.10.2015
(51) Int. Cl.: H01L 29/861, H01L 21/329, H01L 29/06, H01L 29/24

(54) **SEMICONDUCTOR DEVICE AND A METHOD OF MANUFACTURING SAME**

(30) Priority: 14.10.2014 JP 2014209618
(71) Applicant: Hitachi, Ltd., Tokyo 100-8280 (JP); Hitachi Power Semiconductor Device, Ltd., Hitachi-shi, Ibaraki 319-1221 (JP)
(72) Inventor: HASEGAWA, Jiro, Ibaraki, 319-1221 (JP); TOYOTA, Yoshiaki, Tokyo, 100-8280 (JP)
(74) Representative: MERH-IP Matias Erny Reichl Hoffmann Patentanwälte PartG mbB

(57) **Abstract**

In a SiC semiconductor device, the surface of a termination region is covered with a passivation film, and the passivation film comprises a thermal silicon oxide film which is in contact with the surface of the termination region, a first CVD silicon oxide film deposited on the thermal silicon oxide film so as to be in contact with the thermal silicon oxide film, and a second CVD silicon oxide film deposed on the first CVD silicon oxide film so as to be in contact with the first CVD silicon oxide film. By so doing, an electric field applied to the passivation film is relaxed, while production cost is reduced.

## Description

### BACKGROUND OF THE INVENTION

### Field of the Invention

The invention relates to a semiconductor device using silicon carbide as the semiconductor material thereof, and a method of manufacturing the same.

### Description of Prior Art

Efforts are being put into research and development of a semiconductor device using silicon carbide (hereinafter referred to "SiC"), as a new semiconductor material, for use in a semiconductor substrate, by substituting for the traditional silicon (hereinafter referred to "Si"), in an attempt to achieve substantial reduction in power loss of a power device where a large current flows there through, while requiring high blocking voltage. Because SiC has a dielectric breakdown electric-field ten times as large as that of Si, SiC is a semiconductor material capable of causing the thickness of a drift layer for maintaining blocking voltage to be reduced, and carrier concentration to be kept high, thereby reducing conduction loss. For this reason, it is highly hoped that SiC will be applied to a next-generation power device high in blocking voltage, and low in power loss.

In general, with a power device, there is formed a termination structure, such as Junction Termination Extension (JTE), or Field Limiting Ring (FLR), etc., in order to relax an electric field concentration, occurring at the termination of the device in a blocking state. By "blocking state" is meant a state where a high potential difference occurs across the main electrodes of the power device, and no current flows between the primary electrodes.

Now, the principle of operation of JTE is described hereinafter. In the following description, respective signs "p⁺", "p", and "p⁻" indicate that the conductivity type of a semiconductor is P-type, and respective impurity carrier concentrations become relatively lower in that order. Further, respective signs "n⁺", "n", and "n⁻" indicate that the conductivity type of a semiconductor is N-type, and respective impurity carrier concentrations become relatively lower in that order.

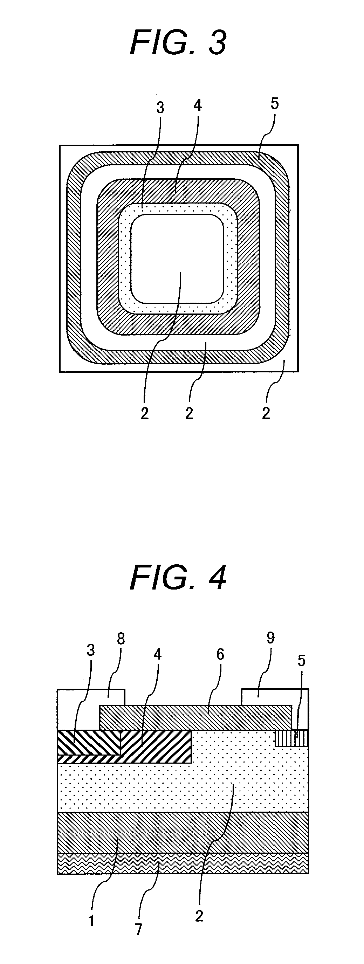

Fig. 4 is a longitudinal sectional view showing an example of a conventional Si diode having a JTE. As shown in Fig. 4, a p⁺ type guard ring region 3, a p-type JTE region 4, and an n⁺ type field stop region 5 are formed on the upper surface of an n⁻ type drift layer 2 formed over an n⁺ type substrate 1. An underside electrode 7 is formed on the underside of the n⁺ type substrate 1. A surface electrode 8, a passivation film 6, and a floating electrode 9 are formed above the n⁻ type drift layer 2 in such a way as to be in contact with the upper surface of the n⁻ type drift layer 2. The floating electrode 9 is electrically coupled to the n⁺ type field stop region 5.

In the blocking state where a high voltage, for example, a voltage at several kV is applied across the underside electrode 7 and the surface electrode 8, shown in Fig. 4, electric lines of force extend from the underside electrode 7 toward the surface electrode 8. At this point in time, the electric lines of force tend to concentrate at the edge of the surface electrode 8, however, the electric lines of force are horizontally spread out due to presence of the p⁺ type guard ring region 3 as well as the p-type JTE region 4, so that the concentration of electric-fields, at the edge of the surface electrode 8, can be relaxed. By so doing, a diode can have higher blocking voltage. Further, with FLR having a plurality of p-type regions, as well, the electric field concentration can be relaxed because the electric lines of force are horizontally spread out in a similar manner.

With an SiC semiconductor device, as well, higher blocking voltage is obtainable by virtue of JTE and FLR, described as above. However, the SiC semiconductor device has the problem of an increase in leakage current, and breakage of a passivation film because of high electric fields applied on the passivation film. In other words, carriers accelerated by the high electric-fields are injected into the passivation film, thereby causing traps to be generated in the passivation film, whereupon a leakage current flows via the traps through tunneling, etc. Further, upon an increase in the number of the traps, large current flows, thereby leading to the breakage of the passivation film. Accordingly, with the termination of a power device using an SiC semiconductor substrate, there is the need for taking it into account that a high electric-field is applied to not only a semiconductor junction structure, such as JTE and FLR, but also to the passivation film.

In this connection, with reference to the passivation film of a termination structure, applied to an SiC power device, the techniques described in Patent Literature 1 (Japanese Patent Application Laid-Open No. Hei 11 (1999) -330496), and Patent Literature 2 (Japanese Patent Application Laid-Open No. 2013 - 42054), respectively, are well known.

With the technique described in Patent Literature 1, the passivation film on a p-type impurity region, forming the termination structure, is of a multi-layer film structure made up of a silicon oxide film in contact with the semiconductor SiC, and a high dielectric film over the silicon oxide film. By so doing, high electric fields applied on the passivation film can be shared by the silicon oxide film and the high dielectric film to prevent the passivation film from deterioration, thereby reducing variation in blocking voltage.

Further, with the technique described in Patent Literature 2, the passivation film over a p-type impurity region, forming the termination structure, is of a multi-layer film structure made up of a first silicon oxide film in contact with SiC, a metal insulating film not less than 0. 3 nm, not more than 10 nm, in thickness, provided on the first silicon oxide film, and a second silicon oxide film provided on the metal insulating film. By so doing, the effective electrical charge of the passivation film can be rendered negative, so that variation in blocking voltage can be reduced.

With the termination structure of the SiC power device, since the high dielectric film, and the metal-oxide film, in addition to the silicon oxide film, are used for preparation of the passivation film, various materials for use in preparing those films are required, or a manufacturing process becomes complex, thereby causing an increase in production cost.

### SUMMARY OF THE INVENTION

Accordingly, it is therefore an object of the present invention to provide an SiC semiconductor device capable of obtaining high blocking voltage, and high reliability, while suppressing an increase in production cost.

According to one aspect of the present invention, there is provided a semiconductor device composed of a semiconductor SiC, having a termination region disposed around an active region, the upper surface of the termination region being covered with a passivation film. The passivation film includes a first silicon oxide film in contact with the upper surface of the termination region, a second silicon oxide film deposited on the first silicon oxide film, so as to be in contact with the first silicon oxide film, and a third silicon oxide film deposited on the second silicon oxide film, so as to be in contact with the second silicon oxide film.

According to another aspect of the present invention, there is provided a method of manufacturing a semiconductor device composed of a semiconductor SiC, incorporating a termination region disposed around an active region, an upper surface of the termination region being covered with a passivation film. The method includes a first step of forming a sacrificial oxide film on a semiconductor surface with thermal oxidation, a second step of forming a first silicon oxide film functioning as the passivation film, on the termination region, by making use of the sacrificial oxide film formed in the first step, a third step of forming a second silicon oxide film over the first thermal silicon oxide film formed by CVD in the second step, and a fourth step of forming a third silicon oxide film functioning as the passivation film over the second silicon oxide film formed by CVD in the third step.

With the semiconductor device according to the present invention, since the passivation film includes the first through the third silicon oxide films, an electric field applied on the passivation film is relaxed, and the passivation film can be provided without the need for a particular process and material, so that production cost can be reduced.

The method of manufacturing the semiconductor device, according to the present invention, includes the step of forming the first silicon oxide film functioning as the passivation film by making use of the sacrificial oxidized film, so that the production cost of an SiC semiconductor device can be reduced.

The other objects, features, and advantages of the present invention will be apparent from the following detailed description of the embodiments of the invention.

### BRIEF DESCRIPTION OF THE DRAWINGS

Fig. 1 is a longitudinal sectional view showing a termination region of an SiC semiconductor device according to one embodiment of the present invention;
Fig. 2 is a longitudinal sectional view showing a termination region of an SiC semiconductor device according to another embodiment of the present invention;
Fig. 3 is a plan view of the SiC semiconductor device according to the first embodiment of the present invention; and
Fig. 4 is a longitudinal sectional view showing an example of a conventional Si diode having a JTE.

### DETAILED DESCRIPTION OF THE PREFERRED EMBODIMENTS

Embodiments of the invention are described below with reference to the accompanying drawings

### First Embodiment

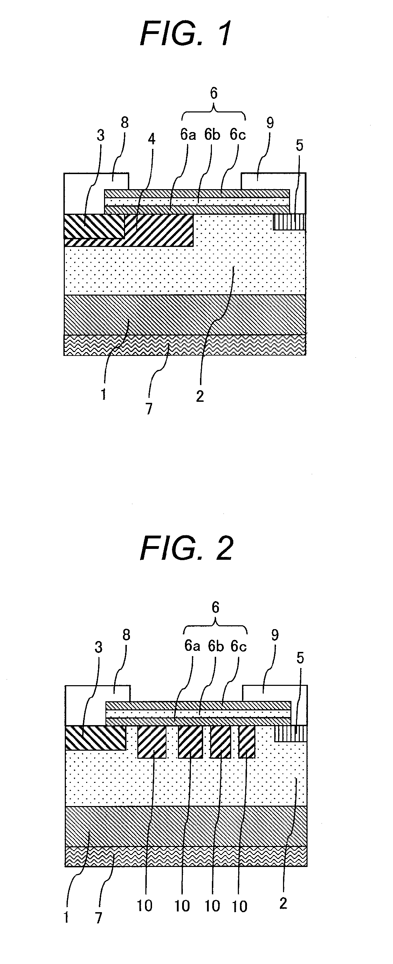

Fig. 1 is a longitudinal sectional view showing a termination region of an SiC semiconductor device according to one embodiment of the present invention. A termination structure according to the present embodiment is applicable to a power device such as a high blocking voltage diode, and a high blocking voltage MOSFET, etc.

As shown in Fig. 1, an n⁻ type drift layer 2 in contact with an n⁺ type substrate 1 is provided on the n⁺ type substrate 1. The n⁺ type substrate 1 together with the n⁻ type drift layer 2 constitutes an n ⁺ n⁻ junction. Herein, the n⁻ type drift layer 2 is formed by use of the epitaxial growth method, and so forth. A p-type JTE region 4 in contact with the n⁻ type drift layer 2, and a p⁺ type guard ring region 3 shallower in depth than the p-type JTE region 4, being in contact with the p-type JTE region 4, are provided on the upper surface of the n⁻ type drift layer 2. Further, an n⁺ type field stop region 5 is provided on the upper surface of the n⁻ type drift layer 2. Each of the p-type JTE region 4, and the n⁺ type field stop region 5, together with the n⁻ type drift layer 2, constitutes pn⁻junction, and n⁺n⁻junction, respectively. The n⁻ type drift layer 2 lies between the p-type JTE region 4, and the n⁺ type field stop region 5, on the upper surface of the n⁻type drift layer 2. In other words, the p-type JTE region 4 is separated from the n⁺ type field stop region 5 without coming into contact with each other. A passivation film, and so forth will be described later on.

Fig. 3 shows a plan view of the semiconductor device according to the present embodiment. In Fig. 3, there is shown a planar pattern of the n⁻ type drift layer 2, the p⁺ type guard ring region 3, the p-type JTE region 4, and the n⁺ type field stop region 5, omitting the passivation film, electrodes, etc. The p⁺ type guard ring region 3, the p-type JTE region 4, and the n⁺ type field stop region 5 each are a single circle in planar shape. Further, the central part of the semiconductor device is an active region of the power device such as a diode, a MOSFET, and so forth. However, detailed configuration thereof is omitted in Fig. 3, showing the n⁻ type drift layer 2 only in Fig. 3 for the sake of brevity. As shown in Fig. 3, the p⁺ type guard ring region 3, the p-type JTE region 4, and the n⁺ type field stop region 5 are disposed in that order starting from the central part of the n⁻ type drift layer 2 toward the end thereof in such a way as to surround the active region positioned at the central part of the n⁻ type drift layer 2, in the semiconductor device. A region positioned around the active region, in a semiconductor chip of the semiconductor device, that is, the region incorporating the p⁺ type guard ring region 3, the p-type JTE region 4, and the n⁺ type field stop region 5 is the termination region. The active region controls the main current, and the termination region relaxes an electric field.

With the embodiment shown in Fig. 1, the p⁺ type guard ring region 3, and the p-type JTE region 4 each are a semiconductor region formed by introducing a p-type impurity {for example, aluminum (Al)} into the upper surface of the n⁻ type drift layer 2 made of SiC, with ion implantation. With the present embodiment, the p⁺ type guard ring region 3 is higher in concentration of the p-type impurity, and shallower in impurity-introduction depth than the p-type JTE region 4. However, magnitude relationship with respect to the impurity concentration and the impurity-introduction depth is not limited thereto, and may be optional, including the case where both the regions are equal to each other in respect of the impurity concentration and the impurity-introduction depth, respectively. The n⁺ type field stop region 5 is a semiconductor region for preventing the electric field applied on the semiconductor device from reaching the end of the semiconductor chip of the semiconductor device, the n⁺ type field stop region 5 being a semiconductor region formed by introducing an n-type impurity {for example, phosphorous (P)} into the upper surface of the n⁻ type drift layer 2 with ion implantation.

As shown in Fig. 1, an underside electrode 7 is provided on the underside of the n⁺ type substrate 1, the underside electrode 7 serving as the main electrode in electrical contact with the n⁺ type substrate 1, and a surface electrode 8 is provided on the upper surface of the n⁻ type drift layer 2, the surface electrode 8 serving as the main electrode in electrical contact with the p⁺ type guard ring region 3. Further, a floating electrode 9 in electrical contact with the upper surface of the n⁻ type drift layer 2 is provided above the upper surface of the n⁻ type drift layer 2. The floating electrode 9 is separated from the underside electrode 7, and the surface electrode 8, respectively, the floating electrode 9 being in a floating-potential state without being connected to either an external electrode or an external circuit, in the present embodiment. The underside electrode 7, the surface electrode 8, and the floating electrode 9 each are made of a conductive material such as aluminum (Al), etc. Further, the floating electrode 9 is capable of equalizing the potential of the n⁺ type field stop region 5, thereby enhancing reliability in a field-stop action of the n⁺ type field stop region 5.

Further, as shown in Fig. 1, a passivation film 6 is positioned between the surface electrode 8 and the floating electrode 9, on the upper surface of the n⁻ type drift layer 2. The surface electrode 8 and the floating electrode 9 are provided such that respective parts thereof overlie the surface of the passivation film 6. Furthermore, the passivation film 6 is provided so as to extend across the surface of an end part of the p⁺ type guard ring region 3, the surface of the p-type JTE region 4, the surface of a part of the n⁻ type drift layer 2, interposed between the p-type JTE region 4 and the n⁺ type field stop region 5, and the surface of an end part of the n⁺ type field stop region 5 in such a way as to cover these surfaces. That is, with the present embodiment, the passivation film 6 is provided across a range from directly above the part of the p⁺ type guard ring region 3 up to directly above the part of the n⁺ type field stop region 5, thereby covering the whole surface of the p-type JTE region 4, and the whole surface of the part of the n⁻ type drift layer 2, interposed between the p-type JTE region 4 and the n⁺ type field stop region 5, within the termination region.

The passivation film 6 is composed of a thermal silicon oxide film 6a, a silicon oxide film 6b formed by deposition including LPCVD (Low Pressure Chemical Vapor Deposition) or PECVD (Plasma Enhanced Chemical Vapor Deposition) to be subsequently put into a vitrification process, and a silicon oxide film 6c formed by deposition including LPCVD or PECVD, which are stacked upward in that order from the upper surface of the n⁻ type drift layer 2. More specifically, the thermal silicon oxide film 6a in a first layer of the passivation film 6 is in contact with the surface of the end part of the p⁺ type guard ring region 3, the surface of the p-type JTE region 4, the surface of the part of the n⁻ type drift layer 2, interposed between the p-type JTE region 4 and the n⁺ type field stop region 5, and the surface of the end part of the n⁺ type field stop region 5, and the CVD silicon oxide film 6b in a second layer of the passivation film 6 is deposited so as to be in contact with the upper surface of the thermal silicon oxide film 6a, while covering the whole surface of the thermal silicon oxide film 6a, whereas the CVD silicon oxide film 6c in a third layer of the passivation film 6 is deposited so as to be in contact with the upper surface of the CVD silicon oxide film 6b, while covering the whole upper surface of the CVD silicon oxide film 6b.

The passivation film 6 according to the embodiment shown in Fig. 1 includes only three layers of inorganic films composed of silicon oxide, however, the upper surface of the passivation film 6 may be covered with a protective film made of resin such as polyimide, and polyamide, etc.

The thermal silicon oxide film 6a of the passivation film 6 is made of a thermal oxide film formed in a sacrificial oxidation process applied for removal of damage incurred due to the ion implantation in the surface of the semiconductor SiC, that is, use is made of a portion of a sacrificial oxide film without removal. Accordingly, the thermal silicon oxide film 6a can be provided without addition of a thermally oxidation process in order to form the passivation film. For this reason, it is possible to obtain the termination structure in which stable blocking voltage can be obtained, and leakage-current is low, without causing an increase in production cost. Further, with the present embodiment, the ion implantation is adopted in order to form the p⁺ type guard ring region 3, the p-type JTE region 4, and the n⁺ type field stop region 5.

In the blocking state where a voltage is applied across the underside electrode 7 and the surface electrode 8 at the time when the SiC semiconductor device according to the present embodiment is in operation, electric lines of force extend from the underside electrode 7 toward the surface electrode 8. With the present embodiment, the electric lines of force are horizontally spread out by the agency of the p⁺ type guard ring region 3 as well as the p-type JTE region 4, so that the concentration of electric-fields at an edge portion of the surface electrode 8, in contact with the p⁺ type guard ring region 3, can be relaxed. Even if a high electric field is applied on the passivation film 6 at this point in time, since the passivation film 6 is made up of three layers, that is, plural layers of the silicon oxide films laid up in decreasing order of compactness in film quality, traps hardly generate in the passivation film. For this reason, it is possible to suppress an increase in leakage current and breakage of the passivation film.

Because the passivation film according to the present embodiment is made up of the three layers of the silicon oxide films as described above, the electric field applied on the passivation film is relaxed, and the passivation film can be provided without the need for a particular process and material, so that production cost can be reduced.

Further, the thermal silicon oxide film is provided over the surface of the semiconductor SiC, and two layers of the CVD oxide films, that is, plural layers thereof are additionally deposited on the thermal silicon oxide film, so that the surface of the semiconductor, that is, the surface of the n⁻ type drift layer 2 which is lightly doped, in particular, can be rendered more stable, and the passivation film can be easily increased in thickness. By so doing, the SiC semiconductor device can have higher blocking voltage, while stabilizing the blocking voltage, thereby enhancing reliability.

As described above, the passivation film 6, is formed by the following steps of a manufacturing process:
(a) the step of forming a sacrificial oxide film on the surface of the semiconductor SiC with thermal oxidation,
(b) the step of forming a thermal silicon oxide film for use in passivation, on the termination region of the semiconductor device, by making use of the sacrificial oxide film formed in the step (a),
(c) the step of forming a silicon oxide film by CVD, over the thermal silicon oxide film for use in passivation, formed in the step (b), and
(d) the step of forming a silicon oxide film by CVD, over the silicon oxide film formed in the step (c).

Thus, the passivation film can be provided without addition of a thermal oxidation step for formation of the thermal oxide film for use in passivation, and without the need for a particular process and material, so that production cost can be reduced.

### Second Embodiment

Fig. 2 is a longitudinal sectional view showing a termination region of an SiC semiconductor device according to another embodiment of the present invention. The second embodiment is described below mainly with respect to points where the present embodiment differs from the first embodiment.

The present embodiment differs from the first embodiment in that a termination region has the FLR structure. As shown in Fig. 2, a portion of the upper surface of an n⁻ type drift layer 2, interposed between a p⁺ type guard ring region 3 and an n⁺ type field stop region 5, is provided with four pieces of p-type FLR regions 10. A portion of the n⁻ type drift layer 2 is interposed between the p⁺ type guard ring region 3 and the p-type FLR region 10 in close proximity thereto, between two pieces of the p-type FLR regions 10 in close proximity to each other, and between the n⁺ type field stop region 5 and the p-type FLR region 10 in close proximity thereto, respectively. In other words, the p⁺ type guard ring region 3, the four pieces of the p-type FLR regions 10, and the n⁺ type field stop region 5 are separated each other. Further, the number of the pieces of the p-type FLR regions 10 can be optionally set in accordance with blocking voltage as desired.

The planar pattern of the present embodiment shows that the four pieces of the p-type FLR regions 10, each being annular in shape, are provided in place of the p-type JTE region 4, shown in Fig. 3, in such a way as to surround the active region between the p⁺ type guard ring region 3 and the n⁺ type field stop region 5, in the termination region.

As shown in Fig. 2, a passivation film 6 is composed of a thermal silicon oxide film 6a, and CVD silicon oxide films 6b and 6c, stacked upward in two layers in that order, over the thermal silicon oxide film 6a, as is the case with the first embodiment. The passivation film 6 is positioned between the surface electrode 8 and a floating electrode 9, over the upper surface of the n⁻ type drift layer 2. The surface electrode 8 and the floating electrode 9 are provided such that respective parts thereof overlie the surface of the passivation film 6. Furthermore, the passivation film 6 is provided so as to extend across the surface of an end part of the p⁺ type guard ring region 3, the surface of each of the four pieces of the p-type FLR regions 10, the surface of a portion of the n⁻ type drift layer 2, interposed between the p⁺ type guard ring region 3 and the p-type FLR region 10 in close proximity thereto, the surface of a portion of the n⁻ type drift layer 2, interposed between two pieces of the p-type FLR regions 10 in close proximity to each other, the surface of a portion of the n⁻ type drift layer 2, interposed between an end part of the n⁺ type field stop region 5 and the p-type FLR region 10 in close proximity thereto, and the surface of the end part of the n⁺ type field stop region 5, in such a way as to cover these surfaces. That is, with the present embodiment, the passivation film 6 is provided across a range from directly above the part of the p⁺ type guard ring region 3 up to directly above the part of the n⁺ type field stop region 5, thereby covering the whole surface of the four pieces of the p-type FLR regions 10, the whole surface of the portion of the n⁻ type drift layer 2, interposed between the p⁺ type guard ring region 3 and the p-type FLR region 10 in close proximity thereto, the whole surface of the portion of the n⁻ type drift layer 2, interposed between two pieces of the p-type FLR regions 10 in close proximity to each other, and the whole surface of the portion of the n⁻ type drift layer 2, interposed between the end part of the n⁺ type field stop region 5 and the p-type FLR region 10 in close proximity thereto, within the termination region.

Otherwise, the second embodiment shown in Fig. 2 is similar to the first embodiment shown in Fig. 1 in respect of configuration and a manufacturing method.

With the second embodiment, it is possible to obtain the termination structure in which stable blocking voltage can be obtained, and leakage current is kept low, without causing an increase in production cost, as is the case with the first embodiment.

It is to be understood that the invention be not limited to the embodiments described in the foregoing and that variations thereto may be made. For example, those embodiments are described for illustrated purposes only so as to render the description to be easily understood and the invention may not necessarily be limited to the embodiment having the whole configuration as described. Furthermore, addition,· deletion,· replacement with the use of another configuration may be applied to a part of each of the embodiments.

For example, a pn junction diode, a Schottky barrier diode, a composite-type diode provided with both a pn-junction and Schottky barrier, a switching device, such as MOSFET, IGBT, etc., are applicable to the semiconductor device provided in the active region. Furthermore, with respect of each of the embodiments, the conductivity types p, n of a semiconductor region may be reversed to n, p, respectively.

## Claims

1. A semiconductor device composed of a semiconductor SiC, including a termination region disposed around an active region, an upper surface of the termination region being covered with a passivation film, wherein the passivation film comprises:
a first silicon oxide film in contact with the upper surface of the termination region;
a second silicon oxide film deposited on the first silicon oxide film, so as to be in contact with the first silicon oxide film; and
a third silicon oxide film deposited on the second silicon oxide film, so as to be in contact with the second silicon oxide film.

2. The semiconductor device according to claim 1,
wherein the first silicon oxide film is a thermal silicon oxide film, whereas the second silicon oxide film, and the third silicon oxide film each are CVD silicon oxide films.

3. The semiconductor device according to claim 2,
wherein the thermal silicon oxide film serving as the first silicon oxide film is a sacrificially oxide film.

4. The semiconductor device according to claim 1,
wherein inorganic films functioning as the passivation film are only three films including the first through the third silicon oxide films.

5. The semiconductor device according to claim 1,
wherein the termination region comprises a JTE structure.

6. The semiconductor device according to claim 1,
wherein the termination region comprises an FLR structure.

7. A method of manufacturing a semiconductor device composed of a semiconductor SiC, including a termination region disposed around an active region, an upper surface of the termination region being covered with a passivation film, the method comprising:
a first step of forming a sacrificial oxide film on a semiconductor surface with thermal oxidation;
a second step of forming a first silicon oxide film functioning as the passivation film, over the termination region, by making use of the sacrificial oxide film formed in the first step;
a third step of forming a second silicon oxide film functioning as the passivation film by CVD over the first silicon oxide film formed in the second step; and
a fourth step of forming a third silicon oxide film functioning as the passivation film by CVD over the second silicon oxide film formed in the third step.
